# FASCICULE DE BREVET EUROPEEN

(11) **EP 0 665 439 B1**
(45) Date de publication et mention de la délivrance du brevet: **17.05.2000**
(21) Numéro de dépôt: 95400056.8
(22) Date de dépôt: 12.01.1995
(51) Int. Cl.: G01R 1/04

(54) **Adaptateur pour machine à tester des équipements électroniques**
Adapter für Testanordnung für elektronische Geräte
Adaptor for test machine for electronic equipment

(30) Priorité: 01.02.1994 FR 9401064
(43) Date de publication de la demande: 02.08.1995
(73) Titulaire: AEROSPATIALE MATRA, 75781 Paris Cédex 16 (FR)
(72) Inventeur: Freneuil, Patrick, F-31100 Toulouse (FR); Ginestet, Bernard, F-31700 Beauzelle (FR); Ortega, José, F-31200 Toulouse (FR)
(74) Mandataire: Bonnetat, Christian

(56) Documents cités:
- EP-A- 0 470 303
- MESURES, vol.53, no.11, 17 Octobre 1988, PARIS,FR pages 51 - 57, XP000093460 RENARD 'un nouveau standard en test?'

## Description

La présente invention concerne un adaptateur pour une machine à tester des équipements électroniques.

Plus particulièrement, quoique non exclusivement, les équipements à tester peuvent être des calculateurs, des dispositifs de mesure ou d'analyse à électronique élaborée et analogues qui sont montés, par exemple, à bord d'aéronefs et qui doivent être contrôlés pour en vérifier le fonctionnement. Cette machine est conçue comme un banc de test permettant de contrôler les différents équipements à tester par l'intermédiaire de l'adaptateur. Il va de soi que tout équipement électronique utilisé dans un quelconque domaine technique peut être contrôlé par une machine spécifique par l'intermédiaire d'un adaptateur approprié, conforme à l'invention.

De tels adaptateurs, qui servent alors d'interface entre les différents équipements à tester et la machine, sont déjà connus (voir EP-A-0 470 303) et ils doivent répondre, notamment dans le domaine aéronautique, à des normes bien précises référencées ARINC-608A, afin de satisfaire aux exigences techniques en vigueur.

Généralement, lesdits adaptateurs se présentent sous la forme d'une boîte au moins approximativement parallélépipédique et comportent :
- un premier ensemble de connecteurs électriques disposés en face avant de ladite boîte et destinés à coopérer avec des connecteurs électriques complémentaires portés par lesdits équipements ;
- un second ensemble de connecteurs électriques disposés en face arrière de ladite boîte et destinés à coopérer avec des connecteurs électriques complémentaires portés par ladite machine ;
- des circuits électriques logés dans ladite boîte et établissant des liaisons électriques entre lesdits premier et second ensembles de connecteurs ; et
- un cadre rigide, solidaire de ladite boîte à la périphérie de la face arrière de celle-ci et destiné à coopérer avec un mécanisme prévu sur ladite machine pour fixer de façon amovible, par sa face arrière, ladite boîte sur ladite machine.

Bien qu'ils donnent des résultats satisfaisants du point de vue fonctionnel, il s'avère que du point de vue structurel, les adaptateurs présentent quelques inconvénients, notamment pendant les opérations de maintenance concernant en particulier les différents circuits et liaisons électriques entre les deux ensembles de connecteurs.

En effet, les connecteurs du second ensemble sont fixés sur la face avant du cadre (ou sur la face arrière de la boîte) de telle sorte que, lorsque la boîte est solidarisée, par sa face arrière, de la face avant du cadre, le démontage des connecteurs se révèle incommode. En effet, ils ne sont alors accessibles qu'à travers ladite boîte, en retirant la face avant de celle-ci, ce qui soulève des difficultés d'accessibilité intérieure en raison des nombreuses liaisons électriques, prévues dans la boîte de l'adaptateur et reliant les différents connecteurs desdits ensembles. De la sorte, les risques de détérioration de fils ou de connexions sont importants lors du démontage des connecteurs du second ensemble, d'autant plus que lesdites liaisons, constituées par des torons de fils électriques et de sous-ensembles appropriés, occupent tout l'espace intérieur dudit adaptateur.

La présente invention a pour but de remédier à ces inconvénients et concerne un adaptateur pour machine à tester des équipements électroniques, dont la conception améliore grandement les diverses opérations de maintenance des circuits électriques et des ensembles de connecteurs logés dans celui-ci.

A cet effet, ledit adaptateur pour machine à tester des équipements électroniques, du type décrit ci-dessus, est remarquable selon l'invention en ce que lesdits connecteurs électriques dudit second ensemble sont montés de façon à pouvoir être mis en place sur ladite boîte et être séparés de celle-ci, à travers ledit cadre rigide.

Ainsi, grâce à l'invention, la maintenance de ces connecteurs du second ensemble, à des fins notamment de réparation de leurs contacts cassés ou tordus, se trouve facilitée puisque, après déverrouillage du mécanisme amovible reliant la machine au cadre de l'adaptateur, lesdits connecteurs sont directement accessibles depuis la face arrière du cadre, sans avoir à recourir à l'ouverture de la face avant de la boîte.

Avantageusement, lesdits connecteurs électriques du second ensemble sont fixés en face avant dudit cadre rigide par des vis de fixation ou analogues dont les têtes sont accessibles depuis la face arrière dudit cadre. Ainsi, les opérations de maintenance relatives à ces connecteurs et à leurs liaisons électriques sont extrêmement aisées puisque, après avoir déverrouillé l'adaptateur de la machine par action sur le mécanisme, il est simplement nécessaire de retirer lesdites vis de fixation pour extraire le ou les connecteurs concernés hors de la boîte, à travers le cadre, et procéder ensuite aux contrôles.

Dans un mode préféré de réalisation, ledit cadre rigide se compose de quatre montants assemblés les uns aux autres et opposés parallèlement deux à deux, lesdits connecteurs du second ensemble s'appliquant à leurs extrémités contre deux desdits montants opposés dudit cadre pour y être fixés. En particulier, les montants opposés du cadre, portant lesdits connecteurs du second groupe, sont identiques et sont alors pourvus de rebords internes respectifs situés en face avant du cadre et tournés l'un vers l'autre, lesdits connecteurs étant amenés en butée contre lesdits rebords internes depuis la face arrière du cadre, pour y être fixés. Quant aux deux autres montants opposés du cadre, également identiques, ils sont pourvus, extérieurement, de douilles d'ancrage saillantes destinées à coopérer avec ledit mécanisme de verrouillage amovible de ladite machine.

Par ailleurs, on sait que le mécanisme de verrouillage, qui est prévu sur la machine et avec lequel coopèrent les douilles correspondantes du cadre, doit garantir une fixation rigoureuse et un maintien efficace de l'adaptateur sur la machine. Cependant, il apparaît à l'usage que, à force de monter et de démonter l'adaptateur, les liaisons du mécanisme avec les douilles du cadre se détériorent, jusqu'à présenter des jeux fonctionnels inacceptables, de sorte qu'il est alors nécessaire de changer de cadre. Cela implique de séparer la boîte dudit cadre à changer et de démonter pour cela bon nombre des circuits électriques.

Aussi, pour faciliter cette opération de changement de cadre, ladite boîte présente avantageusement des ouvertures ménagées dans ses faces latérales et obturables par des panneaux amovibles correspondants, et ledit cadre rigide est monté solidaire de ladite boîte, par sa face arrière, par des organes de fixation, accessibles à travers lesdites ouvertures. Ainsi, on peut procéder aisément au démontage du cadre sans toucher aux circuits électriques, en retirant les panneaux amovibles, puis les organes de fixation à travers lesdites ouvertures, pour remonter un nouveau cadre. Avantageusement, ledit cadre se prolonge, du côté de sa face avant, par des pattes latérales qui sont susceptibles de s'engager dans ladite boîte par sa face arrière, pour être fixées à celle-ci par lesdits organes de fixation.

On remarquera que l'on peut également intervenir à l'intérieur dudit adaptateur pour contrôler un quelconque circuit électrique ou autre, depuis l'une des faces latérales de la boîte après avoir retiré le panneau correspondant.

De préférence, ladite boîte est constituée par une cage d'ossature parallélépipédique délimitant les ouvertures latérales, avant et arrière, par des panneaux amovibles latéraux obturant lesdites ouvertures latérales, et par un panneau amovible avant, qui porte les connecteurs dudit premier ensemble, obturant ladite ouverture avant, tandis qu'au travers de ladite ouverture arrière de ladite cage sont introduites les pattes latérales dudit cadre rigide.

Plus particulièrement, ladite cage d'ossature parallélépipédique est obtenue à partir d'une feuille métallique qui est découpée aux endroits destinés à former lesdites ouvertures, puis pliée et soudée pour constituer ladite cage rigide, celle-ci formant alors des cadres avant et arrière reliés l'un à l'autre par des arêtes. On remarque la simplicité de réalisation de la boîte qui lui confère, par ailleurs, une rigidité importante.

Selon une autre caractéristique de l'invention, puisque les connecteurs électriques du second ensemble sont accessibles depuis la face arrière du cadre, on peut agencer au mieux l'intérieur de la boîte. Pour cela, lesdits circuits électriques peuvent comporter au moins une plaquette isolante à circuit imprimé, disposée parallèlement auxdites faces avant et arrière de ladite boîte et portant des connecteurs électriques intermédiaires entre les connecteurs électriques desdits premier et second ensembles. Des rails de fixation et analogues peuvent être de plus prévus dans ladite cage d'ossature parallélépipédique permettant, par des pièces intermédiaires, d'aménager les circuits électriques à l'intérieur de ladite boîte.

Les figures du dessin annexé feront bien comprendre comment l'invention peut être réalisée. Sur ces figures, des références identiques désignent des éléments semblables.

La figure 1 montre en perspective un équipement électronique à tester monté sur une machine de test par l'intermédiaire d'un adaptateur conforme à l'invention.

La figure 2 est une vue en perspective dudit adaptateur à partir de la face avant de ladite boîte.

La figure 3 est une vue en perspective dudit adaptateur avec la face avant de ladite boîte, retirée, montrant les différents circuits et liaisons électriques.

La figure 4 est une vue en perspective dudit adaptateur à partir de la face arrière dudit cadre, montrant l'accès aux connecteurs correspondants à travers ledit cadre.

La figure 5 est une vue latérale, partiellement en coupe, dudit adaptateur, montrant notamment la fixation du cadre rigide à ladite boîte.

La figure 6 est une vue de dessus partielle, selon la flèche F de la figure 5, de l'assemblage cadre-boîte.

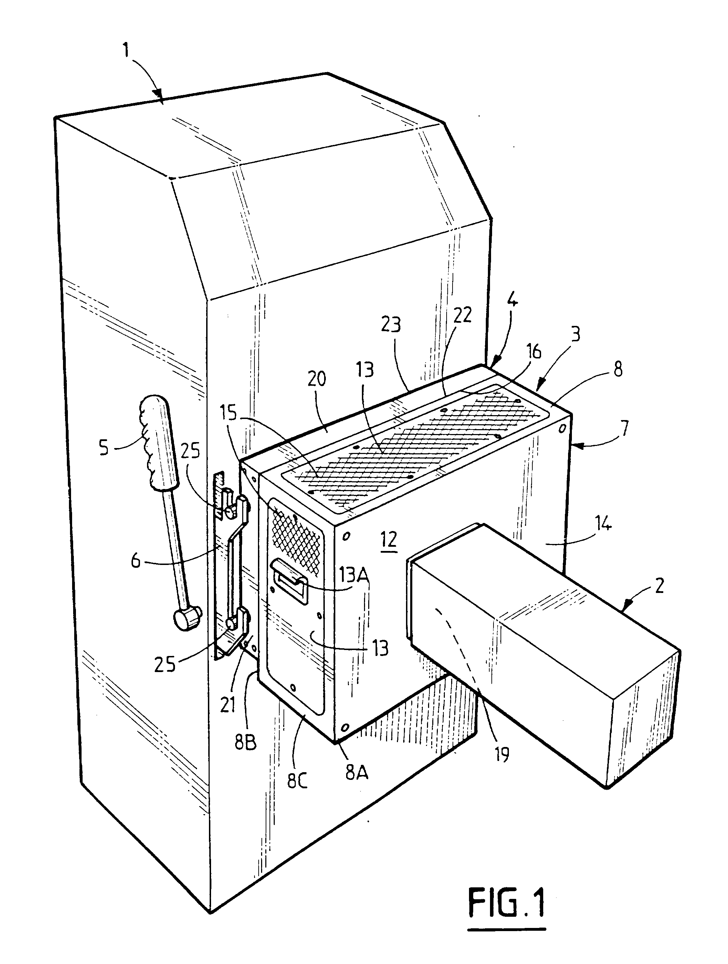

La machine 1 représentée en perspective sur la figure 1 est destinée à tester des équipements électroniques 2, par exemple du type calculateur. Pour ce faire, on prévoit un adaptateur interface 3, pouvant être solidarisé, de façon amovible, de ladite machine 1 par l'intermédiaire d'un cadre rigide 4, solidaire de l'adaptateur 3 et susceptible de coopérer avec un mécanisme de fixation amovible porté par ladite machine 1. Sur la figure 1, seuls la poignée d'actionnement 5 et l'un des deux leviers à crochets 6 de ce mécanisme sont visibles. Un tel mécanisme de fixation peut être de tout type connu, par exemple celui décrit dans le brevet américain US-A-4 329 005.

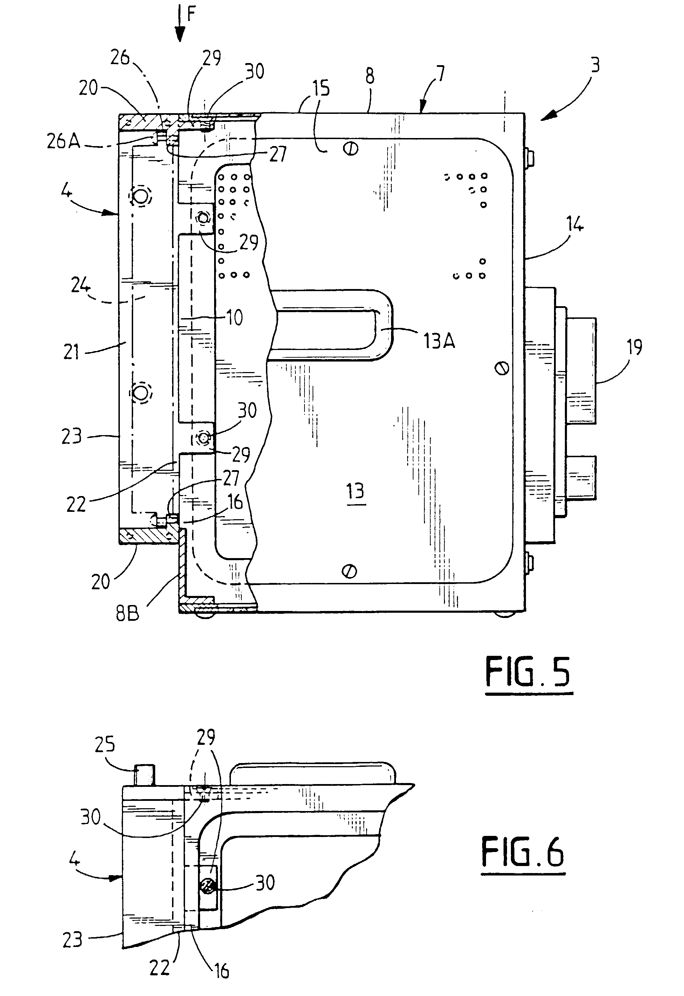

Comme le montrent les figures 1 à 5, l'adaptateur interface 3 se présente sous la forme d'une boîte parallélépipédique 7, constituée d'une cage d'ossature parallélépipédique 8 et de panneaux amovibles 12,13 qui obturent cinq des six ouvertures 9,10,11 délimitées par ladite cage 8, et qui sont destinés à former ainsi, au moins en partie, les faces de ladite boîte 7. La cage d'ossature 8 est, par exemple, obtenue à partir d'une feuille métallique dans laquelle sont tout d'abord découpées les quatre ouvertures latérales 11 et qui est ensuite pliée de façon appropriée, puis soudée pour former ladite cage d'ossature parallélépipédique 8, à six ouvertures. Celle-ci comporte alors un cadre avant rectangulaire auquel sont rapportés fixement quatre montants 8A qui délimitent l'ouverture avant 9, et un cadre arrière rectangulaire, identique au cadre avant et auquel est uniquement rapporté, en partie basse, un montant 8B, ce dernier délimitant avec le cadre arrière, l'ouverture arrière 10. Les deux cadres avant et arrière de la cage 8 sont reliés l'un à l'autre par les quatre arêtes 8C obtenues lors du pliage de la feuille et disposées parallèlement à la profondeur de la cage 8, aux angles latéraux de celle-ci. Les quatre arêtes 8C délimitent alors, avec les cadres avant et arrière, les quatre ouvertures latérales 11 de la cage.

Ainsi, la face avant 14 de la boîte est constituée par le panneau 12 et les montants 8A de la cage, les quatre faces latérales 15 de la boîte par les panneaux latéraux 13 et les arêtes de la cage, tandis que la face arrière 16 de la boîte est essentiellement constituée par le cadre arrière de la cage et le montant 8B, qui délimitent l'ouverture arrière 10.

Les panneaux avant 12 et latéraux 13 sont assemblés par des moyens de fixation, tels que des vis 17, aux montants et arêtes de la cage d'ouverture 8 et ils présentent de plus une pluralité d'orifices traversants 18 destinés à assurer une bonne circulation de l'air à l'intérieur de la boîte de l'adaptateur durant son utilisation. En outre, sur les deux panneaux latéraux et opposés, destinés à être verticaux lors de la manipulation de l'adaptateur, il est prévu des poignées respectives 13A.

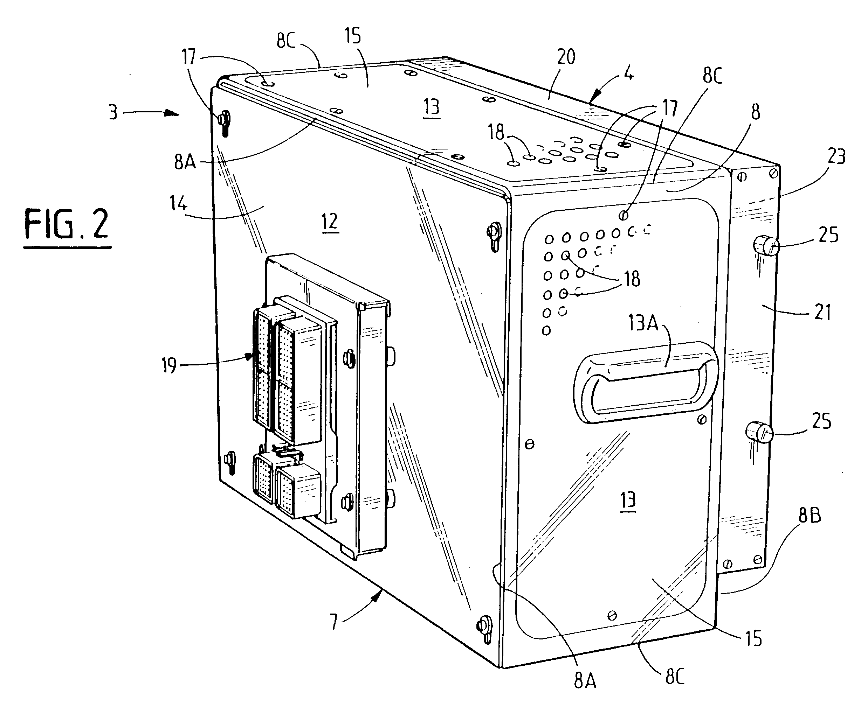

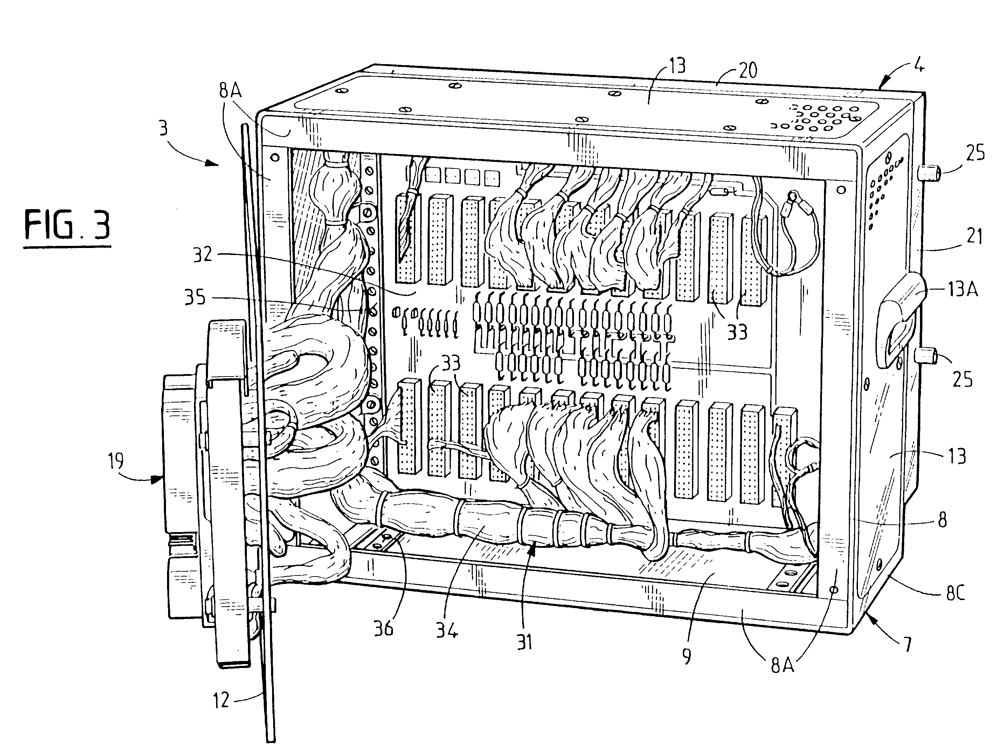

Comme on peut le voir sur les figures 2 et 3, le panneau avant 12 porte, sur sa face externe, un premier ensemble de connecteurs électriques 19 destinés à coopérer avec des connecteurs électriques complémentaires (non représentés) portés par la face arrière de l'équipement 2 à tester. Le montage de l'équipement 2 sur la face externe du panneau avant 12 s'effectue par emboîtement, de façon à garantir un maintien efficace de celui-ci sur l'adaptateur.

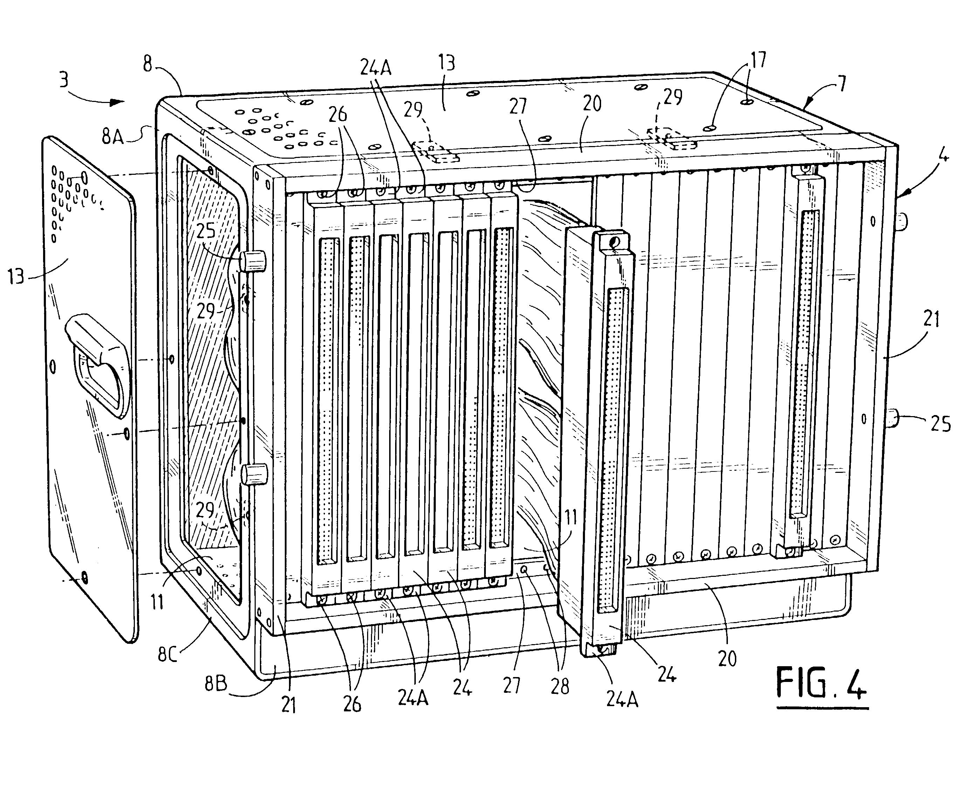

A la face arrière 16 de la boîte est rapporté le cadre rigide 4 qui se compose, dans cet exemple de réalisation, de quatre montants 20,21 assemblés les uns aux autres et opposés parallèlement deux à deux pour former une configuration rectangulaire. Ces quatre montants de section sensiblement rectangulaire délimitent, d'un côté, la face avant 22 du cadre, destinée à coopérer avec la face arrière 16 de la boîte 7 et, de l'autre côté, la face arrière 23 tournée vers ladite machine 1. Comme le montrent notamment les figures 4 à 6, les deux montants opposés et, dans ce cas, horizontaux 20 du cadre sont identiques et sont destinés à porter le second ensemble de connecteurs électriques 24. Quant aux deux autres montants opposés et, alors, verticaux 21, ils sont identiques et portent, chacun, extérieurement, deux douilles cylindriques saillantes 25 pour l'accrochage avec les leviers respectifs 6 du mécanisme de verrouillage amovible de ladite machine 1.

Avantageusement, les connecteurs électriques 24 du second ensemble sont montés sur l'adaptateur pour pouvoir être mis en place sur ou séparés de la boîte 7 à travers ledit cadre rigide 4. Pour cela, ils sont fixés en face avant 22 du cadre par des vis de fixation 26 dont les têtes 26A sont accessibles depuis la face arrière 23 du cadre, ce qui permet alors de procéder à la maintenance des connecteurs sans avoir à démonter le cadre 4 de la boîte 7 pour accéder aux connecteurs. Pour ce faire, comme le montrent plus particulièrement les figures 4, 5 et 6, les deux montants opposés 20 du cadre sont pourvus, du côté de sa face avant 22, de rebords internes respectifs 27 tournés l'un vers l'autre et percés d'une pluralité de trous taraudés 28. Comme les connecteurs 24 sont identiques et, dans ce cas, rectangulaires, les trous taraudés sont équidistants les uns par rapport aux autres. Ainsi, les extrémités 24A des connecteurs s'appliquent contre les rebords internes 27 des montants 20, après avoir été introduits depuis la face arrière 23 du cadre, pour y être fixés par les vis 26 s'engageant dans les trous taraudés 28 desdits montants, alors que leurs têtes 26A s'appliquent sur les extrémités 24A desdits connecteurs. Une fois montés, les connecteurs 24 sont disposés parallèlement les uns par rapport aux autres, comme le montre la figure 4. Sur celle-ci, l'un des connecteurs électriques 24 est représenté en position sortie, hors de la boîte 7, obtenue par un simple dévissage des vis 26 à travers la face arrière 23 du cadre. Ainsi, on peut procéder aux différentes opérations de maintenance de ce connecteur.

Par ailleurs, la fixation du cadre rigide 4 à la boîte 7, également rigide grâce à sa cage 8, est effectuée par l'intermédiaire de pattes latérales 29 prolongeant les montants du cadre et s'engageant dans la boîte par sa face arrière 16, et d'organes de fixation 30. Plus particulièrement, au moins deux pattes espacées l'une de l'autre sont prévues sur chacun des montants 21, verticaux sur les figures, et sur le montant horizontal supérieur 20, de sorte qu'elles font saillie par rapport à la face avant 22 du cadre. Ces pattes 29 s'engagent par l'ouverture arrière 10 du cadre arrière de la boîte, pour s'agencer sous les faces latérales de la cage d'ossature, qui délimitent les ouvertures 11. Et les organes de fixation 30, tels que des vis à tête fraisée, sont montés depuis l'extérieur de la cage, pour se visser dans les pattes et ainsi fixer le cadre à la boîte. Le montage et le démontage du cadre de celle-ci s'effectuent facilement après avoir retiré les panneaux amovibles latéraux 13 de ladite boîte, ce qui est particulièrement appréciable lorsqu'il est nécessaire de changer le cadre quand les douilles d'ancrage 25 sont usées.

En outre, grâce au montage des connecteurs électriques 24 sur le cadre rigide 4 par sa face arrière, on peut aménager l'intérieur de l'adaptateur 3 et notamment la boîte 7, pour présenter au mieux les circuits électriques 31. Pour cela, ces derniers comportent par exemple une plaquette isolante à circuit imprimé 32 disposée à l'intérieur de la boîte 7, parallèlement à ses faces avant 14 et arrière 16, c'est-à-dire aux cadres avant et arrière de la cage 8. Cette plaquette isolante à circuit imprimé 32 est notamment munie de connecteurs électriques intermédiaires 33 reliant les connecteurs électriques 19 et 24 respectivement des premier et second ensembles. Comme le montre la figure 3, on peut alors ordonner au mieux le cheminement des différentes liaisons électriques 34, conformées en torons, pour faciliter ainsi la maintenance de l'adaptateur 3. Sur cette figure, le panneau avant 12, portant le premier ensemble de connecteurs, a été retiré de la cage 8. La plaquette isolante à circuit imprimé 32 peut être maintenue à l'intérieur de celle-ci par des pièces intermédiaires telles que des rails verticaux et horizontaux 35, qui sont fixés à des rails 36 prévus sur la cage d'ossature de la boîte.

## Revendications

1. Adaptateur pour machine à tester des équipements électroniques, destiné à servir d'interface entre ladite machine et lesdits équipements et se présentant sous la forme d'une boîte (7) au moins approximativement parallélépipédique, ledit adaptateur comportant :
- un premier ensemble de connecteurs électriques (19) disposés en face avant de ladite boîte et destinés à coopérer avec des connecteurs électriques complémentaires portés par lesdits équipements ;
- un second ensemble de connecteurs électriques (24) disposés en face arrière de ladite boîte et destinés à coopérer avec des connecteurs électriques complémentaires portés par ladite machine ;
- des circuits électriques (31) logés dans ladite boîte et établissant des liaisons électriques entre lesdits premier et second ensembles de connecteurs ; et
- un cadre rigide (4), solidaire de ladite boîte à la périphérie de la face arrière de celle-ci et destiné à coopérer avec un mécanisme prévu sur ladite machine pour fixer de façon amovible, par sa face arrière, ladite boîte sur ladite machine;
lesdits connecteurs électriques (24) dudit second ensemble étant montés de façon à pouvoir être mis en place sur ladite boîte (7) et être séparés de celle-ci, à travers ledit cadre rigide (4).

2. Adaptateur selon la revendication 1,
caractérisé en ce que lesdits connecteurs électriques (24) du second ensemble sont fixés en face avant (22) dudit cadre rigide par des vis de fixation ou analogues (26) dont les têtes sont accessibles depuis la face arrière (23) dudit cadre.

3. Adaptateur selon l'une des revendications 1 ou 2,
caractérisé en ce que ledit cadre rigide (4) se compose de quatre montants (20,21) assemblés les uns aux autres et opposés parallèlement deux à deux, lesdits connecteurs (24) du second ensemble s'appliquant à leurs extrémités contre deux desdits montants opposés (20) dudit cadre pour y être fixés.

4. Adaptateur selon la revendication 3,
caractérisé en ce que les montants opposés (20) du cadre (4), portant lesdits connecteurs du second groupe, sont identiques et sont pourvus de rebords internes respectifs (27) situés en face avant (22) du cadre et tournés l'un vers l'autre, lesdits connecteurs étant amenés en butée contre lesdits rebords internes depuis la face arrière (23) du cadre, pour y être fixés.

5. Adaptateur selon l'une des revendications 3 ou 4,
caractérisé en ce que lesdits autres montants opposés (21) du cadre sont identiques et sont pourvus, extérieurement, de douilles d'ancrage saillantes (25) destinées à coopérer avec ledit mécanisme de verrouillage amovible (6) de ladite machine.

6. Adaptateur selon l'une quelconque des revendications précédentes 1 à 5,
caractérisé en ce que ladite boîte (7) présente des ouvertures (11) ménagées dans ses faces latérales (15) et obturables par des panneaux amovibles correspondants (13), et en ce que ledit cadre rigide (4) est monté solidaire de ladite boîte, par sa face arrière, par des organes de fixation (30), accessibles à travers lesdites ouvertures.

7. Adaptateur selon la revendication 6,
caractérisé en ce que ledit cadre (4) se prolonge, du côté de sa face avant (22), par des pattes latérales (29) qui sont susceptibles de s'engager dans ladite boîte (7) par sa face arrière (16), pour être fixées à celle-ci par lesdits organes de fixation.

8. Adaptateur selon la revendication 7,
caractérisé en ce que ladite boîte (7) est constituée par une cage d'ossature parallélépipédique (8) délimitant des ouvertures latérales (11), avant (9) et arrière (10), par des panneaux amovibles latéraux (13) obturant lesdites ouvertures latérales, et par un panneau amovible avant (12), qui porte les connecteurs dudit premier ensemble (19), obturant ladite ouverture avant, tandis qu'au travers de ladite ouverture arrière (10) de ladite cage (8) sont introduites les pattes latérales dudit cadre rigide (4).

9. Adaptateur selon la revendication 8,
caractérisé en ce que ladite cage d'ossature parallélépipédique (8) est obtenue à partir d'une feuille métallique qui est découpée aux endroits destinés à former lesdites ouvertures (9,10,11), puis pliée et soudée pour constituer ladite cage rigide (8), celle-ci formant alors des cadres avant et arrière (8A,8B) reliés l'un à l'autre par des arêtes.

10. Adaptateur selon l'une quelconque des revendications précédentes 1 à 9,
caractérisé en ce que lesdits circuits électriques (31) comportent au moins une plaquette isolante à circuit imprimé (32) disposée parallèlement auxdites faces avant (14) et arrière (16) de ladite boîte et portant des connecteurs électriques intermédiaires (33) entre les connecteurs électriques desdits premier et second ensembles.

11. Adaptateur selon l'une quelconque des revendications précédentes 1 à 10,
caractérisé en ce que des rails de fixation (36) sont prévus dans ladite cage d'ossature parallélépipédique (8) permettant, par des pièces intermédiaires, d'aménager les circuits électriques à l'intérieur de ladite boîte.

## Patentansprüche

1. Adapter für Testanordnung für elektronische Geräte, der als Schnittstelle zwischen der genannten Anordnung und den genannten Geräten dienen soll und in Form eines mindesten annähernd quaderförmigen Kastens (7) vorliegt, wobei der genannte Adapter folgendes umfaßt:
- eine erste Einheit von elektrischen Steckverbindern (19), die auf der Vorderseite des genannten Kastens angeordnet sind und mit zusätzlichen, an den genannten Geräten angebrachten elektrischen Steckverbindern zusammenwirken sollen;
- eine zweite Einheit von elektrischen Steckverbindern (24), die auf der Rückseite des genannten Kastens angeordnet sind und mit zusätzlichen, an der genannten Anordnung angebrachten elektrischen Steckverbindern zusammenwirken sollen;
- im genannten Kasten untergebrachte elektrische Schaltkreise (31), die die elektrischen Verbindungen zwischen der genannten ersten und zweiten Steckverbindereinheit herstellen; und
- ein starrer, fest mit dem genannten Kasten verbundener Rahmen (4) am Umfang der Rückseite dieses Kastens, der mit einem an der genannten Anordnung vorgesehenen Mechanismus zusammenwirken soll, um den genannten Kasten an der genannten Anordnung abnehmbar zu befestigen;
wobei die genannten elektrischen Steckverbinder (24) der genannten zweiten Einheit so montiert sind, daß sie über den genannten starren Rahmen (4) am genannten Kasten (7) angebracht und von diesem abgenommen werden können.

2. Adapter gemäß Anspruch 1,
dadurch gekennzeichnet, daß die genannten elektrischen Steckverbinder (24) der zweiten Einheit mit Befestigungsschrauben oder ähnlichen Teilen (26), deren Köpfe von der Rückseite (23) des genannten Rahmens zugänglich sind, auf der Vorderseite (22) des genannten starren Rahmens befestigt werden.

3. Adapter gemäß einem der Ansprüche 1 oder 2,
dadurch gekennzeichnet, daß der genannte starre Rahmen (4) aus vier Stützen (20, 21) besteht, die aneinander montiert sind und von denen jeweils zwei einander parallel gegenüberliegen, wobei die genannten Steckverbinder (24) der zweiten Einheit an ihren Enden an zwei der gegenüberliegenden Stützen (20) des genannten Rahmens anliegen, um dort befestigt zu werden.

4. Adapter gemäß Anspruch 3,
dadurch gekennzeichnet, daß die gegenüberliegenden Stützen (20) des Rahmens (4), auf denen sich den genannten Steckverbinder der zweiten Gruppe befinden, identisch und mit entsprechenden Innenwülsten (27) ausgestattet sind, die sich auf der Vorderseite (22) des Rahmens befinden und zueinander gerichtet sind, wobei die genannten Steckverbinder von der Rückseite (23) des Rahmens her an den genannten Innenwülsten anliegen, um dort befestigt zu werden.

5. Adapter gemäß einem der Ansprüche 3 oder 4,
dadurch gekennzeichnet, daß die genannten anderen gegenüberliegenden Stützen (21) des Rahmens identisch und außen mit vorstehenden Verankerungshülsen (25) versehen sind, die mit dem genannten abnehmbaren Verriegelungsmechanismus (6) der genannten Anordnung zusammenwirken sollen.

6. Adapter gemäß einem beliebigen der vorstehenden Ansprüche 1 bis 5,
dadurch gekennzeichnet, daß der genannte Kasten (7) in seinen Seitenflächen (15) angebrachte Öffnungen (11) besitzt, die mit entsprechenden abnehmbaren Platten (13) verschließbar sind, und dadurch, daß der genannte starre Rahmen (4) über seine Rückseite mittels Befestigungsorganen (30), die durch die genannten Öffnungen zugänglich sind, fest mit dem genannten Kasten verbunden ist.

7. Adapter gemäß Anspruch 6,
dadurch gekennzeichnet, daß sich der genannte Rahmen (4) von seiner Vorderseite (22) her durch seitliche Pratzen (29) verlängert, die von der Rückseite des genannten Kastens (16) in diesen Kasten (7) hineinführen können, um mittels der genannten Befestigungsorgane an dieser Rückseite befestigt zu werden.

8. Adapter gemäß Anspruch 7,
dadurch gekennzeichnet, daß der genannte Kasten (7) aus einem quaderförmigen Tragwerksgehäuse (8) besteht, das vorn (9) und hinten (10) befindliche seitliche Öffnungen (11) abgrenzt durch abnehmbare Seitenplatten (13), die die genannten seitlichen Öffnungen verschließen, sowie durch eine abnehmbare Vorderplatte (12), auf der sich die Steckverbinder der genannten ersten Einheit (19) befinden und die die genannte vordere Öffnung verschließt, während über die genannte hintere Öffnung (10) des genannten Gehäuses (8) die seitlichen Pratzen des genannten starren Rahmens (4) eingesteckt werden.

9. Adapter gemäß Anspruch 8,
dadurch gekennzeichnet, daß man das genannte quaderförmige Tragwerksgehäuse (8) aus einer Metallplatte erhält, die an den Stellen, die die genannten Öffnungen (9, 10, 11) bilden sollen, ausgeschnitten, dann gebogen und geschweißt wird, damit aus ihr das starre Gehäuse (8) entsteht, wobei dieses dann einen vorderen und einen hinteren Rahmen (8A, 8B) bildet, die über Kanten miteinander verbunden sind.

10. Adapter gemäß einem beliebigen der vorstehenden Ansprüche 1 bis 9,
dadurch gekennzeichnet, daß die genannten elektrischen Schaltkreise (31) mindestens eine Isolierplatte mit gedrucktem Schaltkreis (32) umfassen, die parallel zur Vorder- (14) und zur Rückseite (16) des genannten Kastens angeordnet und mit elektrischen Zwischensteckverbindern (33) zwischen den elektrischen Steckverbindern der genannten ersten beziehungsweise zweiten Einheit ausgerüstet sind.

11. Adapter gemäß einem beliebigen der vorstehenden Ansprüche 1 bis 10,
dadurch gekennzeichnet, daß Befestigungsschienen (36) im genannten quaderförmigen Tragwerksgehäuse (8) vorgesehen sind, die über Zwischenteile die Anordnung von elektrischen Schaltkreisen im Inneren des genannten Kastens ermöglichen.

## Claims

1. Adaptor for a machine for testing electronic equipment, intended to serve as interface between the said machine and the said equipment and being presented in the form of an at least approximately parallelepipedic box (7), the said adaptor including:
- a first set of electrical connectors (19) arranged on the front face of the said box and intended to interact with complementary electrical connectors carried by the said equipment;
- a second set of electrical connectors (24) arranged on the rear face of the said box and intended to interact with complementary electrical connectors carried by the said machine;
- electrical circuits (31) housed in the said box and establishing electrical links between the said first and second sets of connectors; and
- a rigid frame (4), integral with the said box at the periphery of the rear face of the latter, and intended to interact with a mechanism provided on the said machine for removably fixing the said box onto the said machine, by its rear face,
the said electrical connectors (24) of the said second set being mounted in such a way as to be able to be put in place on the said box (7) and to be separated from the latter, through the said rigid frame (4).

2. Adaptor according to Claim 1, characterized in that the said electrical connectors (24) of the second set are fixed onto the front face (22) of the said rigid frame by fixing screws or the like (26), the heads of which are accessible from the rear face (23) of the said frame.

3. Adaptor according to either of Claims 1 and 2, characterized in that the said rigid frame (4) consists of four struts (20, 21) assembled to one another and opposite in parallel pairs, the said connectors (24) of the second set being applied at their ends against two of the said opposite struts (20) of the said frame in order to be fixed there.

4. Adaptor according to Claim 3, characterized in that the opposite struts (20) of the frame (4) carrying the said connectors of the second group, are identical and are provided with respective inner rims (27) situated on the front face (22) of the frame and turned towards one another, the said connectors being brought into abutment against the said inner rims from the rear face (23) of the frame, in order to be fixed there.

5. Adaptor according to either of Claims 3 and 4, characterized in that the said other opposite struts (21) of the frame are identical and are provided externally with projecting anchoring bushes (25) intended to interact with the said removable locking mechanism (6) of the said machine.

6. Adaptor according to any one of the preceding Claims 1 to 5, characterized in that the said box (7) has openings (11) formed in its side faces (15) and closeable by corresponding removable panels (13), and in that the said rigid frame (4) is mounted secured to the said box, by its rear face, by fixing elements (30), accessible through the said openings.

7. Adaptor according to Claim 6, characterized in that the said frame (4) is extended, on its front face (22) side, by lateral lugs (29) which are capable of engaging in the said box (7) by its rear face (16), in order to be fixed to the latter by the said fixing elements.

8. Adaptor according to Claim 7, characterized in that the said box (7) consists of a parallelepipedic framework cage (8) delimiting lateral (11) front (9) and rear (10) openings, of removable side panels (13) closing off the said lateral openings, and of a removable front panel (12), which carries the connectors of the said first set (19), closing off the said front opening, while the lateral lugs of the said rigid frame (4) are inserted through the said rear opening (10) of the said cage (8).

9. Adaptor according to Claim 8, characterized in that the said parallelepipedic framework cage (8) is obtained from a metal sheet which is cut out at the sites intended to form the said openings (9, 10, 11), then bent and welded in order to constitute the said rigid cage (8), the latter then forming front and rear frames (8A, 8B) linked to one another by edges.

10. Adaptor according to any one of the preceding Claims 1 to 9, characterized in that the said electrical circuits (31) include at least one insulating printed circuit board (32) arranged parallel to the said front (14) and rear (16) faces of the said box, and carrying intermediate electrical connectors (33) between the electrical connectors of the said first and second sets.

11. Adaptor according to any one of the preceding Claims 1 to 10, characterized in that fixing rails (36) are provided in the said parallelepipedic framework cage (8) making it possible, by intermediate pieces, to lay out the electrical circuits within the said box.
